Europäisches Patentamt

European Patent Office

Office européen des brevets

(11) Publication number: **0 213 774 B1**

# EUROPEAN PATENT SPECIFICATION

(45) Date of publication of patent specification: **23.10.91**

(51) Int. Cl.⁵: **H01B 5/16**, H01R 9/00, H01L 21/66, G01R 31/28

(21) Application number: **86305991.1**

(22) Date of filing: **04.08.86**

(54) **Anisotropically electrically conductive article.**

(30) Priority: **05.08.85 GB 8519620**
**24.06.86 GB 8615425**

(43) Date of publication of application:
**11.03.87 Bulletin 87/11**

(45) Publication of the grant of the patent:
**23.10.91 Bulletin 91/43**

(84) Designated Contracting States:
**AT BE CH DE FR GB IT LI NL SE**

(56) References cited:
**EP-A- 0 147 856**
**DD-A- 221 903**
**DE-B- 2 652 683**
**US-A- 4 504 783**

(73) Proprietor: **RAYCHEM LIMITED**
**Rolls House 7, Rolls Buildings Fetter Lane**
**London, EC4 1NL(GB)**

(72) Inventor: **Svendsen, Leo Gulvad**
**4 Mayfield Close Nythe**
**Swindon Wiltshire(GB)**
Inventor: **Bates, Nigel Robert**
**20 Keyneston Road Nythe**
**Swindon Wiltshire(GB)**

(74) Representative: **Jay, Anthony William et al**
**Raychem Limited Intellectual Property Law**
**Department Faraday Road**
**Dorcan Swindon Wiltshire(GB)**

Rank Xerox (UK) Business Services

## Description

This invention relates to anisotropically electrically conductive articles and methods of making them.

It is known from U.S. Patent No. 3303085 to produce porous mica sheets in which relatively straight-line pores of 5 to 20,000 Angstroms diameter, produced by heavy particle radiation followed by etching of the mica, are simply filled with superconductive material or iron particles to provide oriented single domain ferromagnetic sheet, or with material suitable for imaging in television cameras. The surfaces of the mica sheet may be polished or abraded to assure electrical contact with the conductive filler.

Porous polymer sheets in which selected areas of the interconnecting pores are masked and the unmasked pores are metal plated to provide anisotropically electrically conductive spots surrounded by insulating areas, are known from Japanese Published Patent Application 80161306.

DD-A1-221903 describes drilling of vias in printed circuit boards by means of an infrared laser which pyrolyses the board material, the resulting conductive carbon surface being subsequently electroplated to connect circuitry lying on opposite surfaces of the board.

DE-B2-2652683 describes uniaxially conductive articles comprising conductive fibres embedded in an elastomeric sheet, and US-A-4504783 describes the use of similar "wires in rubber" strips for temporarily connecting the bonding sites of integrated circuit chips to corresponding test circuitry bonding sites.

The present invention concerns anisotropically electrically conductive articles which tend to provide enhanced electrical contact together with high selectivity, owing to the special arrangement of the electrically conductive material in the pores of a sheet material.

The invention accordingly provides an anisotropically electrically conductive article comprising porous electrically insulating sheet material of 8 to 800 micrometres thickness at least a selected portion of which has a plurality of substantially non-interconnected pores of 1 to 200 micrometres diameter formed therein by laser ablation, which pores individually contain a tubular formation of electrically conductive material, which tubular formation, and/or further electrically conductive material at least partly positioned within the tubular formation, projects beyond at least one of the main surfaces of the sheet material and provides an electrically conductive path between the main surfaces of the sheet material and each such path is electrically separate from substantially all the other such paths.

The diameter and distribution of the pores will preferably be such that the pores occupy from 3 to 35 percent, more preferably 10 to 20 percent, of the sheet surface area. Pores of less than 500, e.g. 5 to 150, micrometres diameter are preferred.

While a "significant proportion" of the pores in the selected areas, for example at least 10%, preferably at least 20%, more preferably at least 30% or better still at least 40%, may contain the conductive material, it is preferred that a majority (more than 50%) do so. Proportions of at least 70%, or better still at least 85% are preferred, and in many cases, substantially all of the pores will contain the conductive material. The pores, whether containing the conductive material or not, may be confined to selected areas of the sheet.

It is preferable that the conductive material project beyond both main surfaces of the sheet material, the projections from either surface preferably being, for example, 0.2 to 100 micrometres in height, preferably 0.5 to 30 micrometres.

The insulating sheet material will preferably be a flexible polymeric material, and the number of pores per square millimetre of the sheet material (whether flexible polymeric or not) may be as high as 250000, for example, up to 50000, or up to 25000, or up to 10000, but will preferably be in the range from 25 to 2000, more preferably 25 to 1000. The pores will preferably have a tortuosity factor (mean path length/ sheet thickness) less than 3, preferably less than 1.2; and will preferably have an aspect ratio (pore length/ pore diameter) of at least 2.5.

Although the "electrically conductive" paths between the sheet surfaces may give the sheet an average electrical conductivity in the thickness direction within the semiconductive range, it is preferable to achieve generally metallic levels of conductivity, e.g. at least 1000 Siemens per centimetre, preferably at least 5000 Siemens, especially at least 10000 Siemens per centimetre. The preferred conductive materials are metals, preferably plated, especially electrolessly plated, on the interior surface of the pores. Any suitably applicable metals may be used, for example Ni, Cu, Ag, Au, Co, Pd, Pd-Ni, Su, Pb, Pb-Sn.

In a preferred form of the articles according to this invention, at least a selected portion of the sheet has a plurality (at least 4, preferably at least 8, more preferably 25 to 1000) of substantially non-interconnected pores per square millimetre of its surface.

The invention could be used to provide solder "posts" supported by the tubular formation, for use in making soldered connections to microcircuits. Gold filling material could also be used to make such "permanent" electrical connections.

Preferably, the tubular formation comprises a first portion of electrically conductive material on the interior pore surface, and a second portion of material, which could be electrically insulating (e.g. an adhesive) but is preferably electrically conductive material, on at least one of the end surfaces of the first portion, at least the parts of the second portion on one or both of the end surfaces of the first portion projecting beyond the sheet surface(s). Preferably, the first portion of electrically conductive material on the pore surface is tubular and the second portion of electrically conductive material is on the interior surface as well as the end surface(s) of the first portion. The first portion is preferably metal and is preferably plated, especially electrolessly plated, on the interior pore surface, and the second portion is preferably metal plated, especially electrolesly plated, on the first portion. The first and second portions respectively may comprise different electrically conductive materials, and the second portion may fill the tubular first portion or may itself be tubular, in which case it may be filled with further electrically conductive material. Where the metal-lined pores are filled with another metal, this will preferably be a solder, a low-melting-point metal, a fusible alloy, or a plated metal. Either the tubular metal lining or the metal fillings, or both, may project beyond the sheet surface(s), and the other criteria mentioned above may apply as appropriate.

If desired, electrically insulating material may be removed from one or both surfaces of the sheet material to expose portions of the electrically conductive material originally within the pores, thus producing or increasing the desired projections of the conductive material beyond the sheet surface(s). This may be done by any convenient means, for example by dissolving away a surface layer of the sheet material, for which purpose a sheet having surface layers of materials more readily soluble in a selected solvent than the underlying layers may be used.

Any electrically insulating sheet material which is suitably porous may be used, preferred polymeric materials including those acceptable to the electronics industry, for example epoxies, polyurethanes, polyimides, silicone rubbers, polysulphones and polycarbonates. The sheet may carry an adhesive layer on one or both of its surfaces if desired for its intended end use.

The invention includes methods of making the articles in question comprising:

(a) applying a first portion of electrically conductive material to the interior surface of the pores in at least a selected portion of an appropriate porous electrically insulating sheet material,

(b) removing any electrically conductive material from at least selected areas of the opposed main surfaces of the sheet material, and

(c) applying a second portion of electrically conductive material to at least one of the end surfaces of the first portion, preferably to substantially all accessible surfaces of the first portion.

Sheet material with low tortuosity porous structure acceptable for producing the anisotropic electrically conductive articles is produced by laser ablation.

The polymeric sheet is masked and subjected to overall ablation of the exposed areas by laser light of low wavelength (350 to 150 nanometres). Any patterned screen limiting the laser light (e.g. a pierced metal screen) will give rise to the same pattern being reproduced on the polymeric sheet. Tubular pores greater than 5 micrometres in diameter can be produced by this method, and piercing through 0.5 millimetre thick layers is possible by extended exposure of e.g. epoxy, polyurethane, polyimide, or polysulphone sheets. Alternatively, a focussed laser beam of any suitable wavelength could be used to drill individual holes.

Preferred methods of making the articles in question from an insulating sheet material, produced by the above-mentioned method, may comprise, by way of example, the following steps:

a Rendering the polymeric sheet suitable for electroless plating by conditioning the surface of the sheet with a catalyst.

b Optionally coating the entire sheet with a thin metal layer by electroless plating.

c Removing the catalyst (and the thin metal layer if present) from the sheet surface.

d Electrolessly plating to produce a thicker metal layer in the tubes and to create small projections from the pores.

e Optionally polishing smooth the ends of the tubes.

f Optionally:

- Electro- or electroless plating in the pores to partially or completely fill the pores with metal; or

- Embedding solder or any fusible low melting metal inside the metal lined pores by, e.g., wave-soldering or capillary absorption or any other suitable method;

- Introducing a non-metal into the metal lined pores, for example a flux or an adhesive.

- Removing elctrically insulating material (e.g. a laminate layer) from one or both main surfaces of the sheet material so as to expose portions of the electrically conductive material originally within the pores.

When the pores are to be filled with molten metal, e.g. solder, it is preferred that the tubular layer within the pores be of sufficient thickness, e.g. at least 0.5, preferably 1.0, more preferably at least 3 micrometres, to avoid being completely removed by the pore filling operation.

The aforementioned removal of any electrically conductive material from the sheet surface before application of the second portion of conductive material may be effected by any convenient means. When, as is preferred, a very thin "sheen" or "flash" coating of metal is plated onto the sheet material, this may be removed from the surface by simple friction, e.g. wiping, leaving the metal only in the pores to act as a catalyst or base for commencement of the second application. In practice, below 15% pore area per surface unit area it does not matter whether the holes are in a random pattern (e.g. made by particle bombardment) or in an ordered pattern (e.g. made by U.V.-laser ablation), but above 15% pore area per surface unit area an ordered pattern is preferred to reduce the risk of overlapping pores. The enormous possible number of cylindrical holes, each with a conductive metallic tube inside, allows a very high number of conductors (vias) between two interconnected devices when the hole diameter is adjusted to the device contact pad size (at least down to 25 sq. micrometre). The large number of vias per pad allows for a very high redundancy if the connection between pad and vias are broken either by bad production of the metallised pores or unfortunate mounting or due to thermal or mechanical shocks. The high potential number of straight through holes combined with the small pore size also allows for a lenient alignment of interconnects made by this method.

The porous sheets may be made of high performance polymers able to withstand severe mechanical handling and high temperatures, and may be transparent. When this is the case the sheets are easy to handle, and it is possible to solder the tubes either by having solder inside them from beforehand or by letting solder soak into the tubes during the soldering. Both approaches will give a good electrical connection. The solder connection may give satisfactory bond strength, or this may be enhanced by providing an adhesive layer on the sheet surface or inside the metal tubes. The transparency allows for automatic mounting procedures which use light shone through the screen.

An anisotropically conductive membrane according to the invention may be prepared as described in the following examples:

Example 1

A polymeric sheet, e.g. polyurethane or epoxy, is exposed to UV-radiation from a high energy laser-source. The setting of an Excimer laser could for example be: wave-length 193 nanometres, pulse energy 300 mJ, repetition rate 120 Hz, beam area 3.22 square centimetre, masking screen 125 micrometres diameter holes 20% porosity 125 micrometres thick reflective stainless steel. The ablation rate would typically be 0.1 to 0.5 micrometres per shot, depending on the number of double-bonds in the polymer and the energy per shot. The present example would produce a pierced polymeric sheet with a 130 micrometre entrance hole (side towards the laser) and a 100 micrometre exit hole in a 450 micrometre thick sheet; this, however, can be altered within wide boundaries, e.g.: hole sizes from 5 to 200 micrometres and thicknesses from 8 to 800 micrometres, as long as one allows for approximately one degree tapering.

The sheet was rinsed in a warm soapy water solution to remove the debris from the drilling process.

The sheet was then treated in a commercial catalyst, Shipley Cataposit 44 (Trade Mark), washed in water and dipped in a commercial accelerator, Shipley Cuposit Acclerator 19 (Trade Mark), and finally washed.

The catalytic sheet was plated in a commercial electroless plating bath, Shipley Cuposit CP-78, until a shine of copper appeared on the surface.

The sheet was then removed and the surface polished with a rotary electric cotton polisher to remove the copper and catalyst on the surface. Loose debris from the polishing was washed off in an ultrasonic water bath.

The sheet was then plated in the same copper-bath till a thickness of 4 microns inside the holes and with a similar protrusion on both sides.

The sheet, with tubular copper lining inside the holes, was run through a wave-soldering apparatus and the eutectic solder filled the holes by means of the capillary forces. On the side facing away from the solder wave the solder stood approximately 25 micrometres proud of the hole; on the side facing the solder wave a similar protrusion occurred but with a more rounded shape of the solder surface. No bridging occurred.

Example 2

A sheet of 310 micrometre thick epoxy was laminated with 64 micrometre thick polycarbonate sheet on both sides. The laminate with a total thickness of 440 micrometre was then treated as in Example 1.

After the holes had been furnished with solder filled copper spikes the polycarbonate was washed away in tetrahydrofuran and the spikes now stood out 88 micrometres each side.

Example 3

A sheet of 310 micrometres thick polyurethane was laminated with a 40 micrometre hot melt on the surface (PTFE rollers) and the drilling as in Example 1 was carried out holding the sheet only at the edges in a PTFE frame.

Afterwards the procedure in Example 1 was followed, but it was ensured that the sheet was held out from the jig when wave-soldering.

Example 4

A sheet, 425 micrometres thick, made of epoxy filled with 40 pphr (parts per hundred resin) phenolic micro balloons had holes drilled by the UV-Laser ablation method mentioned in Example 1. The epoxy sheet henceforth has a tubular porous structure within a closed cell porous structure. This makes the sheet more compliant and more shock resistant when applied in an electrical device.

The sheet was rendered catalytic the same way as described in Example 1, but the plating was commenced in a commercial electroless nickel-copper bath, Shipley Niculoy 22 (Trade Mark), both for the primary sheen plating and the following thickening of the metal tubes.

The metallized tubes were filled with a partially curing contact adhesive by using a silk-screen-printer for the squeezing of adhesive into the pores.

Example 5

A laminate, consisting of five layers: A centre polyimide layer, thickness: 75 micrometres, sandwiched between two 25 micrometres thick polysulphone layers and with two outer sacrificial layers of 2 micrometres butyle rubber, is drilled with an excimer laser as specified in Example 1, wavelength 308 nm.

The normal aqueous rinsing steps are applied to the drilled sheet; followed by the palladium/tin catalyst and accelerator.

The catalyst and the sacrificial layers are now rubbed off the surfaces to leave catalyst only inside the holes.

Copper is electrolessly plated to 8 micrometers thickness. Afterwards the resulting copper tubes are polished smooth on a one micrometer grit diamond polisher.

The rinsed substrate with polished copper tubes is placed in an electroless gold bath to coat all exposed copper with 0.5 micrometres gold coating.

Finally, the polysulphone is dissolved in dichloromethane leaving a polyimide sheet with smooth-ended 25 micrometre protruding gold plated copper tubes.

Articles according to this invention may be used in an electrical device or assembly process in which one or more temporary or permanent electrical connections are made by contact with the opposite ends of the electrically conductive material located in the pores. Testing of microcircuits before or during assembly into electronic devices may especially benefit from the ability of the present articles to make fast, reliable temporary connections between microchip connector pads and the contact pads of a suitable circuit board. Unacceptable chips can thus be rejected before any expensive bonding or connection operations.

**Claims**

1. A anisotropically electrically conductive article comprising porous electrically insulating sheet material of 8 to 800 micrometres thickness at least a selected portion of which has a plurality of substantially non-interconnected pores of 1 to 200 micrometres diameter formed therein by laser ablation, which pores individually contain a tubular formation of electrically conductive material which tubular formation, and/or further electrically conductive material at least partly positioned within the tubular formation, projects beyond at least one of the main surfaces of the sheet material and provides an electrically conductive path between the main surfaces of the sheet material and each such path is electrically separate from substantially all the other such paths.

2. An article according to claim 1, having at least 4 of the said pores per square millimetre in the selected portion of its surface.

3. An article according to claim 2, wherein the sheet material has 25 to 2000 pores per square millimetre in the selected portion of its surface.

4. An article according to any preceding claim, wherein the conductive material in at least some of the said pores comprises a tubular first portion of electrically conductive material in contact with the pore interior surface, and a second portion of material in contact with the interior surface of the tube provided by the first portion.

5. An article according to claim 4, wherein the second portion of material is also tubular.

6. An article according to claim 4 or 5, wherein the material of the said second portion is different from the electrically conductive material of the said first portion.

7. An article according to any preceding claim, wherein electrically conductive metal, fusible alloy or solder is within the tube provided by the tubular electrically conductive material.

8. An article according to any preceding claim, wherein the conductive material in at least some of the said pores comprises a first portion of electrically conductive material in contact with the interior pore surface, and a second portion of electrically conductive material on at least one of the end surfaces of the first portion, at least the second portion projecting beyond at least one of the sheet surfaces.

9. An article according to any preceding claim, wherein the said pores have a tortuosity less than 3, preferably less than 1.2.

10. An article according to any preceding claim, wherein electrically insulating material has been removed from one or both main surfaces of the sheet material to expose portions of the electrically conductive material originally within the pores.

11. An article according to any preceding claim, wherein the electrically insulating sheet material includes a closed cell porous structure in addition to the said pores containing the elecrically conductive material.

12. An article according to any preceding claim, wherein the said pores are 5 to 200, preferably 5 to 150, micrometres in diameter.

13. An article according to any preceding claim, wherein the said tubular formation is formed of metal, preferably plated metal.

14. A method of making an article according to any of the preceding claims comprising:
    (a) applying a first portion of electrically conductive material to the interior surface of the pores in at least a selected portion of an appropriate porous electrically insulating sheet material,
    (b) removing any electrically conductive material from at least selected areas of the opposed main surfaces of the sheet material, and
    (c) applying a second portion of electrically conductive material to at least part of the surface of the first portion.

15. A method according to claim 14, comprising the additional step of removing electrically insulating material from one of both main surfaces of the sheet material so as to expose portions of the electrically conductive material originally within the pores.

16. A method according to claim 14 or 15, including the preliminary step of forming the said pores in the sheet material by laser ablation.

17. An electrical device in which one or more temporary or permanent electrical connections are made by contact with the opposite ends of the electrically conductive material located in the pores of an article according to any of claims 1 to 13.

18. A process for testing semiconductive integrated circuit chips, wherein testing circuitry is temporarily electrically connected to an unbonded chip by contact of connection sites of the testing circuitry and the chip respectively with opposite ends of the electrically conductive material located in the pores of an article according to any of claims 1 to 13.

## Revendications

1. Article doué de conductibilité électrique anisotrope, comprenant une matière poreuse, électriquement isolante, en feuille de 8 à 800 micromètres d'épaisseur, dont au moins une portion choisie possède un grand nombre de pores pratiquement non interconnectés de 1 à 200 micromètres de diamètre formés dans cette feuille par ablation au laser, pores qui contiennent individuellement une formation tubulaire constituée d'une matière électriquement conductrice, la formation tubulaire, et/ou une matière électriquement conductrice supplémentaire positionnée au moins partiellement à l'intérieur de la formation tubulaire, s'étendant au-delà d'au moins l'une des surfaces principales de la matière en feuille et réalisant un trajet électriquement conducteur entre les surfaces principales de la matière en feuille, chacun de ces trajets étant électriquement distinct de pratiquement tous les autres de ces trajets.

2. Article suivant la revendication 1, comprenant au moins 4 des pores par millimètre carré dans la portion choisie de sa surface.

3. Article suivant la revendication 2, dans lequel la matière en feuille possède 25 à 2000 pores par millimètre carré dans la portion choisie de sa surface.

4. Article suivant l'une quelconque des revendications précédentes, dans lequel la matière conductrice dans au moins certains des pores comprend une première portion tubulaire de matière électriquement conductrice en contact avec la surface intérieure des pores, et une seconde portion de matière en contact avec la surface intérieure du tube produit par la première portion.

5. Article suivant la revendication 4, dans lequel la seconde portion de matière est également tubulaire.

6. Article suivant la revendication 4 ou 5, dans lequel la matière de la seconde portion est différente de la matière électriquement conductrice de la première portion.

7. Article suivant l'une quelconque des revendications précédentes, dans lequel un métal électriquement conducteur, un alliage fusible ou de la soudure est présent à l'intérieur du tube produit par la matière tubulaire électriquement conductrice.

8. Article suivant l'une quelconque des revendications précédentes, dans lequel la matière conductrice dans au moins certains des pores comprend une première portion de matière électriquement conductrice en contact avec la surface intérieure des pores et une seconde portion de matière électriquement conductrice sur au moins une des surfaces terminales de la première portion, au moins la seconde portion s'étendant au-delà d'au moins l'une des surfaces de la feuille.

9. Article suivant l'une quelconque des revendications précédentes, dans lequel les pores possèdent une tortuosité inférieure à 3, de préférence inférieure à 1,2.

10. Article suivant l'une quelconque des revendications précédentes, dans lequel la matière électriquement isolante a été éliminée de l'une des, ou des deux, surfaces principales de la matière en feuille pour mettre à découvert des portions de la matière électriquement conductrice présente initialement à l'intérieur des pores.

11. Article suivant l'une quelconque des revendications précédentes, dans lequel la matière électriquement conductrice en feuille comprend une structure poreuse à cellules fermées en plus des pores contenant la matière électriquement conductrice.

12. Article suivant l'une quelconque des revendications précédentes, dans lequel les pores possèdent des diamètres de 5 à 200, de préférence de 5 à 150, micromètres.

13. Article suivant l'une quelconque des revendications précédentes, dans lequel la formation tubulaire est constituée d'un métal de préférence d'un métal de placage.

14. Procédé de production d'un article suivant l'une quelconque des revendications précédentes, consistant :
   (a) à appliquer une première portion de matière électriquement conductrice à la surface intérieure des pores dans au moins une portion choisie d'une matière appropriée poreuse en feuille, électriquement isolante,
   (b) à éliminer n'importe quelle matière électriquement conductrice d'au moins des zones choisies des surfaces principales opposées de la matière en feuille, et
   (c) à appliquer une seconde portion de matière électriquement conductrice à au moins une partie de la surface de la première portion.

15. Procédé suivant la revendication 14, comprenant l'étape supplémentaire consistant à éliminer la matière électriquement isolante de l'une des, ou des deux, surfaces principales de la matière en feuille, de manière à mettre à découvert des portions de la matière électriquement conductrice présente initialement à l'intérieur des pores.

16. Procédé suivant la revendication 14 ou 15, comprenant l'étape préliminaire consistant à former les pores dans la matière en feuille par ablation au laser.

17. Dispositif électrique dans lequel une ou plusieurs connexions électriques temporaires ou permanentes sont réalisées par contact avec les extrémités opposées de la matière électriquement conductrice située dans les pores d'un article suivant l'une quelconque des revendications 1 à 13.

18. Procédé pour tester des microplaquettes à circuits intégrés semiconducteurs, dans lequel les circuits d'essai sont connectés électriquement de manière temporaire à une microplaquette non liée par contact de sites de connexion des circuits d'essai et de la microplaquette respectivement aux extrémités opposées de la matière électriquement conductrice située dans les pores d'un article suivant l'une quelconque des revendications 1 à 13.

## Patentansprüche

1. Anisotrop elektrisch leitfähiger Gegenstand, umfassend ein poröses elektrisch isolierendes Flächenmaterial einer Dicke von 8 bis 800 μm, wobei in wenigstens einem ausgewählten Bereich desselben durch Laserablation eine Vielzahl von im wesentlichen nicht miteinander verbundenen Poren mit einem Durchmesser von 1 bis 200 μm gebildet ist, die jeweils eine rohrförmige Ausbildung aus elektrisch leitfähigem Material enthalten, wobei die rohrförmige Ausbildung und/oder wenigstens teilweise in der rohrförmigen Ausbildung positioniertes weiteres elektrisch leitfähiges Material über wenigstens eine der Hauptoberflächen des Flächenmaterials vorsteht und zwischen den Hauptoberflächen des Flächenmaterials einen elektrisch leitfähigen Pfad bildet und jeder dieser Pfade von im wesentlichen sämtlichen übrigen derartigen Pfaden elektrisch getrennt ist.

2. Gegenstand nach Anspruch 1, der in dem ausgewählten Bereich seiner Oberfläche wenigstens 4 der genannten Poren pro mm² hat.

3. Gegenstand nach Anspruch 2, wobei das Flächenmaterial in dem ausgewählten Bereich seiner Oberfläche 25 bis 2000 Poren pro mm² hat.

4. Gegenstand nach einem der vorhergehenden Ansprüche, wobei das leitfähige Material in wenigstens einigen der genannten Poren einen rohrförmigen ersten Teil aus elektrisch leitfähigem Material in Kontakt mit der Poreninnenfläche und einen zweiten Materialteil in Kontakt mit der Innenfläche des vom ersten Teil gebildeten Rohrs umfaßt.

5. Gegenstand nach Anspruch 4, wobei der zweite Materialteil ebenfalls rohrförmig ist.

6. Gegenstand nach Anspruch 4 oder 5, wobei das Material des zweiten Teils von dem elektrisch leitfähigen Material des genannten ersten Teil verschieden ist.

7. Gegenstand nach einem der vorhergehenden Ansprüche, wobei elektrisch leitfähiges Metall, eine schmelzbare Legierung oder Lot sich in dem von dem rohrförmigen elektrisch leitfähigen Material gebildeten Rohr befindet.

8. Gegenstand nach einem der vorhergehenden Ansprüche, wobei das leitfähige Material in wenigstens einigen der genannten Poren einen ersten Teil aus elektrisch leitfähigem Material in Kontakt mit der Poreninnenfläche und einen zweiten Teil aus elektrisch leitfähigem Material an wenigstens einer der Endflächen des ersten Teils umfaßt, wobei wenigstens der zweite Teil über wenigstens eine der Flächenkörperoberflächen vorsteht.

9. Gegenstand nach einem der vorhergehenden Ansprüche, wobei die genannten Poren eine Verwindung von weniger als 3, bevorzugt weniger als 1,2, haben.

10. Gegenstand nach einem der vorhergehenden Ansprüche, wobei von einem oder beiden Hauptoberflächen des Flächenmaterials elektrisch isolierendes Material entfernt ist, um ursprünglich in den Poren befindliche Teile des elektrisch leitfähigen Materials freizulegen.

11. Gegenstand nach einem der vorhergehenden Ansprüche, wobei das elektrisch isolierende Flächenmaterial zusätzlich zu den das elektrisch leitfähige Material enthaltenden Poren eine geschlossenzellige poröse Struktur aufweist.

12. Gegenstand nach einem der vorhergehenden Ansprüche, wobei die genannten Poren einen Durchmesser von 5 bis 200 μm, bevorzugt 5 bis 150 μm, haben.

13. Gegenstand nach einem der vorhergehenden Ansprüche, wobei die rohrförmige Ausbildung aus Metall, bevorzugt einer Metallplattierung, gebildet ist.

14. Verfahren zur Herstellung eines Gegenstands nach einem der vorhergehenden Ansprüche, umfassend folgende Schritte:
    (a) Aufbringen eines ersten Teils aus elektrisch leitfähigem Material auf die Innenfläche der Poren in wenigstens einem ausgewählten Teil eines geeigneten porösen elektrisch isolierenden Flächenmaterials,
    (b) Entfernen jeglichen elektrisch leitfähigen Materials von wenigstens ausgewählten Bereichen der entgegengesetzten Hauptoberflächen des Flächenmaterials, und
    (c) Aufbringen eines zweiten Teils aus elektrisch leitfähigem Material auf wenigstens einen Teil der Oberfläche des ersten Teils.

15. Verfahren nach Anspruch 14, umfassend folgenden zusätzlichen Schritt: Entfernen von elektrisch isolierendem Material von einer der beiden Hauptoberflächen des Flächenmaterials, um ursprünglich in den Poren befindliche Teile des elektrisch leitfähigen Materials freizulegen.

16. Verfahren nach Anspruch 14 oder 15, umfassend den vorbereitenden Schritt der Bildung der genannten Poren in dem Flächenmaterial durch Laserablation.

17. Elektrische Vorrichtung, bei der ein oder mehrere vorübergehende oder permanente elektrische Anschlüsse durch Kontakt mit den entgegengesetzten Enden des in den Poren eines Gegenstands nach einem der Ansprüche 1 bis 13 befindlichen elektrisch leitfähigen Materials hergestellt sind.

18. Verfahren zum Prüfen von IC-Halbleiterchips, wobei eine Prüfschaltung durch Kontakt von Anschlußstellen der Prüfschaltung bzw. des Chips mit entgegengesetzten Enden des in den Poren eines Gegenstands nach einem der Ansprüche 1 bis 13 befindlichen elektrisch leitfähigen Materials mit einem nichtgebondeten Chip vorübergehend elektrisch verbunden wird.